# EUROPÄISCHE PATENTSCHRIFT

(11) **EP 3 198 639 B1**
(45) Veröffentlichungstag und Bekanntmachung des Hinweises auf die Patenterteilung: **11.09.2019**
(21) Anmeldenummer: 15738271.4
(22) Anmeldetag: 08.07.2015
(51) Int. Cl.: H01L 23/492

(54) **VERFAHREN ZUM HERSTELLEN EINER HALBLEITERANORDNUNG SOWIE ENTSPRECHENDE HALBLEITERANORDNUNG**
METHOD FOR PRODUCING A SEMI-CONDUCTOR ARRANGEMENT AND CORRESPONDING SEMI-CONDUCTOR ARRANGEMENT
PROCÉDÉ DE FABRICATION D'UN DISPOSITIF À SEMI-CONDUCTEUR ET DISPOSITIF À SEMI-CONDUCTEUR CORRESPONDANT

(30) Priorität: 27.09.2014 DE 102014014473
(43) Veröffentlichungstag der Anmeldung: 02.08.2017
(73) Patentinhaber: Audi AG, 85045 Ingolstadt (DE)
(72) Erfinder: VETTER, Günter, 72393 Burladingen (DE); APELSMEIER, Andreas, 85131 Pollenfeld (DE); SUCKEL, Henning, 80809 München (DE)
(86) Internationale Anmeldenummer: PCT/EP2015/001393
(87) Internationale Veröffentlichungsnummer: WO 2016/045758

(56) Entgegenhaltungen:
- CN-A- 101 521 188
- US-A- 4 950 843
- US-A1- 2005 127 134

## Beschreibung

Die Erfindung betrifft ein Verfahren zum Herstellen einer Halbleiteranordnung, mit wenigstens einem Basiselement und einem Halbleiter, wobei der Halbleiter mittels einer Sinterschicht an dem Basiselement befestigt wird. Die Erfindung betrifft weiterhin eine Halbleiteranordnung.

Die Halbleiteranordnung besteht zumindest aus dem Basiselement und dem Halbleiter. Das Basiselement liegt beispielsweise als Grundplatte beziehungsweise Bodenplatte vor. Das Basiselement kann als Kühlkörper dienen, über welchen an dem Halbleiter anfallende Wärme an eine Umgebung der Halbleiteranordnung abgeführt wird. Der Halbleiter soll vorzugsweise lotfrei, also ohne Lot, an dem Basiselement befestigt sein. Zu diesem Zweck ist die wenigstens eine Sinterschicht vorgesehen, welche zwischen dem Halbleiter und dem Basiselement vorliegt.

Dabei ist es nicht notwendigerweise vorgesehen, dass die Sinterschicht unmittelbar an dem Basiselement und/oder unmittelbar an dem Halbleiter anliegt, also beispielsweise unmittelbar zwischen dem Basiselement und dem Halbleiter angeordnet ist. Vielmehr kann es durchaus vorgesehen sein, dass zwischen dem Basiselement und dem Halbleiter wenigstens eine Zwischenschicht vorliegt.

Es kann nun vorgesehen sein, dass diese Zwischenschicht mittels der Sinterschicht an dem Basiselement befestigt wird, insbesondere unmittelbar, sodass also die Sinterschicht einerseits an der Zwischenschicht und andererseits an dem Basiselement anliegt. Eine weitere Sinterschicht kann zur Befestigung des Halbleiters an der Zwischenschicht dienen, sodass also beispielsweise die weitere Sinterschicht sowohl an dem Halbleiter als auch an der Zwischensicht anliegt.

Während eines Betriebs einer solchen Halbleiteranordnung kann es zu einer erheblichen Temperaturbelastung kommen, durch welche thermische Spannungen erzeugt werden, welche insbesondere auf den Halbleiter und/oder die Sinterschicht wirken. Dies kann zu einer raschen Alterung der Halbleiteranordnung führen, weil sich insbesondere Risse in der Sinterschicht bilden.

US 2003/0075785 offenbart ein Verfahren zum Leiten eines Halbleiterchips zu einem Substrat über einen Leiterrahmen, so dass die Verbindung gegenüber Spannungen beständig ist, die sich bei Temperaturänderungen ergeben.

Es ist daher Aufgabe der Erfindung, ein Verfahren zum Herstellen einer Halbleiteranordnung vorzuschlagen, welches gegenüber dem Stand der Technik Vorteile aufweist, insbesondere den vorstehend genannten Nachteil in Form der Rissbildung aufgrund der thermischen Spannungen vermeidet oder zumindest verringert.

Dies wird erfindungsgemäß mit einem Verfahren mit den Merkmalen des Anspruchs 1 erreicht. Dabei ist vorgesehen, dass ein an der Sinterschicht unmittelbar anliegender Bereich des Basiselements zumindest bereichsweise perforiert wird. In zumindest einem Bereich des Basiselements steht insoweit die Sinterschicht in Berührkontakt mit diesem. Dieser Bereich wird zumindest teilweise perforiert, also mit wenigstens einer Ausnehmung versehen.

Die Ausnehmung kann grundsätzlich beliebig ausgestaltet sein. Beispielsweise liegt sie in Form einer Durchtrittsausnehmung oder einer Sackausnehmung vor, wobei erstere das Basiselement durchgreift, während letztere einen geschlossenen Boden aufweist. Die Sackausnehmung ist dabei vorzugsweise lediglich in Richtung der Sinterschicht geöffnet, durchgreift eine Oberfläche des Basiselements also in demjenigen Bereich, an welchem die Sinterschicht unmittelbar anliegt.

Mithilfe der Perforierung kann die Steifigkeit des Basiselements gezielt angepasst und mithin sein Ausdehnungsverhalten beeinflusst werden. Auf diese Art und Weise wird die Belastung der Sinterschicht aufgrund der thermischen Spannungen deutlich verringert, sodass die Lebensdauer der Halbleiteranordnung verbessert wird.

In einer weiteren Ausgestaltung der Erfindung ist vorgesehen, dass das Perforieren vor dem Befestigen des Halbleiters an dem Basiselement vorgenommen wird. Das Basiselement weist also die Perforation beziehungsweise die wenigstens eine Ausnehmung bereits vor dem Vorgang des Sinterns und/oder vor dem Aufbringen des Grünlings, aus welchem die Sinterschicht besteht, auf. Dies stellt grundsätzlich die einfachste und kostengünstigste Ausgestaltung dar.

Die Sinterschicht beziehungsweise der Grünling ist auf ihrer dem Basiselement zugewandten Seite plan ausgestaltet beziehungsweise plan an dem Basiselement nliegen, sodass die Sinterschicht nicht in die Durchtrittsausnehmungen eingreift.

In einer weiteren bevorzugten Ausgestaltung der Erfindung ist vorgesehen, dass das Perforieren das Herstellen von wenigstens einer Ausnehmung, insbesondere einer Vielzahl von Ausnehmungen, den Bereich des Basiselements umfasst. Vorstehend wurde bereits darauf hingewiesen, dass die Perforierung die wenigstens eine Ausnehmung aufweist. Besonders bevorzugt ist jedoch die Vielzahl von Ausnehmungen realisiert, wobei die Ausnehmungen insbesondere voneinander beabstandet in dem Bereich des Basiselements vorliegen. Dabei können die Ausnehmungen identisch oder verschieden voneinander aufgebaut sein.

Beispielsweise ist wenigstens ein Teil der Ausnehmung, insbesondere alle Ausnehmungen, im Querschnitt kreisrund. Ein weiterer Teil der Ausnehmungen oder alternativ alle Ausnehmungen können jedoch auch langlochartig ausgestaltet sein, also beispielsweise im Querschnitt oval oder stadionförmig ausgebildet sein. Unter letzterem ist zu verstehen, dass die Ausnehmung im Querschnitt gesehen von zwei zueinander parallelen geraden Linien begrenzt wird, welche beidseitig jeweils mittels einer gebogenen Linie, beispielsweise einem Halbkreis, miteinander verbunden sind.

Zusätzlich oder alternativ kann wenigstens ein Teil der Ausnehmungen als Durchgangsausnehmung vorliegen. Vorzugsweise sind alle Ausnehmungen als Durchgangsausnehmungen ausgestaltet. Zusätzlich oder alternativ kann jedoch auch weiterer Teil als Sackausnehmung vorliegen. Beispielsweise sind alle Ausnehmungen als Sackausnehmungen ausgestaltet. Die Ausnehmungen können in einer Ausgestaltung jeweils denselben Abstand voneinander aufweisen. Sie können jedoch auch unregelmäßig über den Bereich verteilt angeordnet sein.

In einer weiteren Ausgestaltung der Erfindung ist vorgesehen, dass die wenigstens eine Ausnehmung als randgeschlossene Durchtrittsausnehmung ausgebildet wird. Auf die Ausgestaltung der Ausnehmung als Durchtrittsausnehmung wurde bereits vorstehend eingegangen. Darunter ist zu verstehen, dass die Ausnehmung das Basiselement vollständig durchgreift. Jedoch soll die Ausnehmung derart in dem Basiselement vorliegen, dass sie im Querschnitt gesehen randgeschlossen ist, also im Querschnitt gesehen eine geschlossene Begrenzung aufweist. Sie soll insbesondere einen Rand des Basiselements nicht durchgreifen.

In einer weiteren bevorzugten Ausgestaltung der Erfindung ist vorgesehen, dass das Basiselement eine ebene Fläche aufweist, die von der wenigstens einen Ausnehmung durchgriffen wird und an der die Sinterschicht nach dem Befestigen des Halbleiters anliegt. Derjenige Bereich des Basiselements, an welchem die Sinterschicht anliegt, soll folglich eben sein beziehungsweise als ebene Fläche vorliegen.

Eine Weiterbildung der Erfindung sieht vor, dass das Basiselement derart ausgebildet wird, dass sich an die ebene Fläche ein bezüglich der Fläche abgewinkelter Bereich des Basiselements anschließt. Das Basiselement ist insoweit nicht vollständig plan ausgestaltet, sondern weist neben der ebenen Fläche, an welcher die Sinterschicht anliegt, den abgewinkelten Bereich auf. Beispielsweise ist der abgewinkelte Bereich ebenfalls plan und schließt mit der ebenen Fläche einen Winkel von mindestens 10°, mindestens 20°, mindestens 30°, mindestens 40°, mindestens 45°, mindestens 50°, mindestens 60°, mindestens 70°, mindestens 80° oder genau 90° ein. Der Winkel beträgt in jedem Fall höchstens 90°.

Es kann vorgesehen sein, dass beidseitig der ebenen Fläche jeweils ein derartiger abgewinkelter Bereich unmittelbar an sie anschließt. Zudem kann zusätzlich oder alternativ vorgesehen sein, dass sich auf einer der ebenen Fläche abgewandten Seite des Bereichs eine weitere ebene Fläche anschließt, welche zu der ebenen Fläche parallel sein kann. Anders ausgedrückt schließen sich an den Bereich des Basiselements, an welchem die Sinterschicht unmittelbar anliegt, Bereiche an, die in Normalenrichtung der ebenen Fläche weiter von der Sinterschicht beabstandet sind als die ebene Fläche. Vorzugsweise sind diese weiteren Bereiche nicht perforiert, sondern vielmehr massiv ausgestaltet. Diese Bereiche können insbesondere als Kühlrippen vorliegen, über welche die an dem Halbleiter anfallende Wärme an eine Umgebung der Halbleiteranordnung abgegeben wird.

In einer Weiterbildung der Erfindung ist vorgesehen, dass an dem Halbleiter vor dem Befestigen eine Kontaktschicht angebracht wird. Der Halbleiter wird insoweit nicht unmittelbar, sondern vielmehr lediglich mittelbar über die Kontaktschicht mittels der Sinterschicht an dem Basiselement befestigt. Insbesondere erfolgt eine Befestigung der Kontaktschicht an dem Basiselement mittels der Sinterschicht, sodass also die Sinterschicht sowohl an dem Basiselement als auch an der Kontaktschicht unmittelbar anliegt.

In einer vorteilhaften Ausgestaltung der Erfindung ist vorgesehen, dass als Kontaktschicht eine DCB-Schicht oder eine IMS-Schicht verwendet wird. Die Kontaktschicht kann insoweit auch als Kontaktsubstrat, die DCB-Schicht als DCB-Substrat und die IMS-Schicht als IMS-Substrat bezeichnet werden. Unter einer DCB-Schicht ist ein mehrlagiger Aufbau aus zwei außenseitigen Kupferschichten und einer Zwischenschicht zu verstehen. Die Zwischenschicht besteht beispielsweise aus Keramik oder Aluminium, insbesondere aus Al₂O₃, Si₃N₄ oder AlN. Unter der IMS-Schicht (IMS: Insulated Metal Substrate) ist beispielsweise eine Aluminiumkernleiterplatte zu verstehen.

Schließlich kann vorgesehen sein, dass als Halbleiter in IGBT, eine Diode oder ein MOSFET verwendet wird. Grundsätzlich kann der Halbleiter jedoch beliebig ausgestaltet sein. Bei den genannten Ausführungen tritt jedoch die Problematik der thermischen Spannungen besonders deutlich zutage.

Die Erfindung betrifft weiterhin eine Halbleiteranordnung gemäß Anspruch 7, insbesondere hergestellt gemäß den vorstehenden Ausführungen, mit wenigstens einem Basiselement und einem Halbleiter, wobei der Halbleiter mittels einer Sinterschicht an dem Basiselement befestigt ist. Dabei ist vorgesehen, dass ein an der Sinterschicht unmittelbar anliegender Bereich des Basiselements zumindest bereichsweise perforiert ist. Auf die Vorteile einer derartigen Ausgestaltung der Halbleiteranordnung beziehungsweise des Verfahrens wurde bereits eingegangen. Sowohl die Halbleiteranordnung als auch das Verfahren können gemäß den vorstehenden Ausführungen weitergebildet sein, sodass insoweit auf diese verwiesen wird.

Die Erfindung wird nachfolgend anhand der in der Zeichnung dargestellten Ausführungsbeispiele näher erläutert, ohne dass eine Beschränkung der Erfindung erfolgt. Dabei zeigt
- Figur 1: eine Querschnittsdarstellung durch einen Bereich einer Halbleiteranordnung, die ein Basiselement und einen mittels einer Sinterschicht an dem Basiselement befestigten Halbleiter aufweist, und
- Figur 2: eine Detaildarstellung des Basiselements.

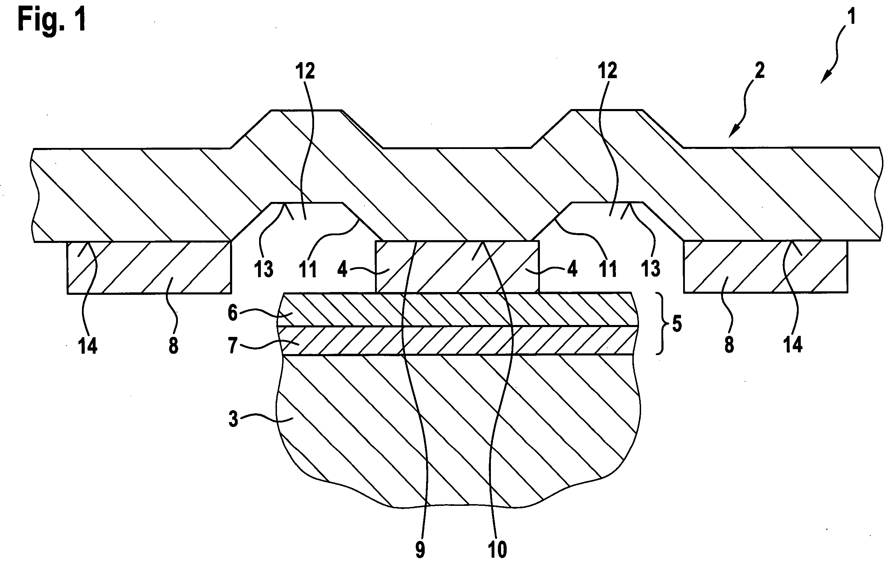

Die Figur 1 zeigt eine Querschnittsdarstellung einer Halbleiteranordnung 1 mit einem Basiselement 2 und einem Halbleiter 3, welcher hier lediglich ausschnittsweise dargestellt ist. Der Halbleiter 3 ist mittels einer Sinterschicht 4 an dem Basiselement 2 befestigt. Die Sinterschicht 4 greift zu diesem Zweck einerseits unmittelbar an dem Basiselement 2 und andererseits unmittelbar an einer Kontaktschicht 5 an, welche beispielsweise als DCB-Schicht ausgebildet ist und insoweit eine Kupferschicht 6 und eine Substratschicht 7 aufweist. Die Substratschicht 7 besteht vorzugsweise aus Al₂O₃.

Neben der Sinterschicht 4 kann wenigstens eine weitere Sinterschicht, in dem hier dargestellten Ausführungsbeispiel zwei weitere Sinterschichten 8, vorgesehen sein. Die Sinterschicht 8 liegt in einem Bereich 9 des Basiselements 2 unmittelbar an diesem an, wobei das Basiselement 2 in diesem Bereich eine ebene Fläche 10 aufweist. In der hier dargestellten Ansicht der Halbleiteranordnung 1 wird deutlich, dass sich an die ebene Fläche 10 ein abgewinkelter Bereich 11 des Basiselements 2 anschließt. Vorzugsweise liegt auf jeder Seite der Fläche 10 ein derartiger Bereich 11 vor.

Durch die Bereiche 11 sind Vertiefungen 12 in dem Basiselement 2 ausgebildet, deren Grund 13 vorzugsweise eben ist und zu der ebenen Fläche 10 parallel verläuft. Auf der der Fläche 10 beziehungsweise der Substratschicht 7 abgewandten Seite der Vertiefung 12 kann eine weitere ebene Fläche 14 vorliegen, auf welcher die Sinterschicht 8 ausgebildet ist. Die Fläche 14 kann parallel zu der Fläche 10 und/oder in derselben gedachten Ebene wie diese vorliegen.

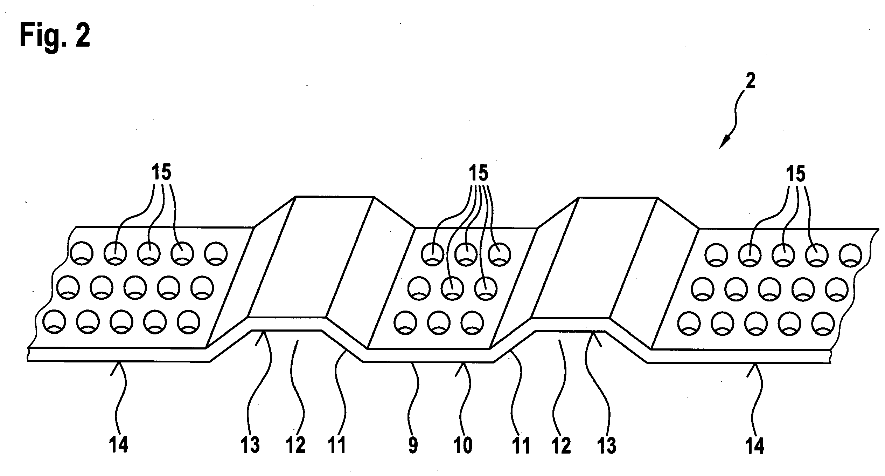

Die Figur 2 zeigt eine Detailansicht des Basiselements 2. Es wird deutlich, dass das Basiselement 2 in dem Bereich 9, in welchem die Sinterschicht 4 (hier nicht dargestellt) unmittelbar anliegt, zumindest bereichsweise perforiert ist, also wenigstens eine Ausnehmung 15, insbesondere eine Vielzahl von Ausnehmungen 15 aufweist, von welchen hier lediglich einige beispielhaft gekennzeichnet sind. Analog hierzu kann auch die Fläche 14, auf welcher ebenfalls eine Sinterschicht 8 vorliegen kann, mit wenigstens einer derartigen Ausnehmung 15 versehen sein. Auch hier sind lediglich einige der Ausnehmungen 15 beispielhaft gekennzeichnet. Es ist zu erkennen, dass die Ausnehmungen 15 als Durchtrittsausnehmungen ausgebildet sind und im Querschnitt randgeschlossen sowie kreisrund sind. Selbstverständlich können die Ausnehmungen 15 jedoch auch als Sackausnehmungen vorliegen und/oder jede beliebige andere Querschnittsausgestaltung aufweisen.

Mittels der Perforation des Bereichs 9 und vorzugsweise auch der Fläche 14 kann die Steifigkeit des Basiselements 2 bereichsweise verringert werden, sodass bei thermischen Spannungen zwischen der Sinterschicht 4 und dem Basiselement 2 eine elastische Verformung des Basiselements 2 leichter möglich ist. Auf diese Art und Weise werden Beschädigungen der Sinterschicht 4 und/oder des Halbleiters 3 aufgrund dieser thermischen Spannungen verhindert oder zumindest verringert.

## Patentansprüche

1. Verfahren zum Herstellen einer Halbleiteranordnung (1), mit wenigstens einem Basiselement (2) und einem Halbleiter (3), wobei der Halbleiter (3) mittels einer Sinterschicht (4) an dem Basiselement (2) befestigt wird, **dadurch gekennzeichnet, dass** ein an der Sinterschicht (4) unmittelbar anliegender Bereich (9) des Basiselements (2) zum gezielten Anpassen der Steifigkeit des Basiselements (2) zumindest bereichsweise perforiert wird, wobei das Perforieren das Herstellen einer Vielzahl von das Basiselement (2) durchgreifenden randgeschlossenen Durchtrittsausnehmungen (15) in dem Bereich (9) des Basiselements (2) umfasst, wobei die Sinterschicht (4) auf ihrer dem Basiselement (2) zugewandten Seite plan ausgestaltet wird, sodass die Sinterschicht (4) nicht in die Durchtrittsausnehmungen (15) eingreift.

2. Verfahren nach Anspruch 1, **dadurch gekennzeichnet, dass** das Perforieren vor dem Befestigen des Halbleiters (3) an dem Basiselement (2) vorgenommen wird.

3. Verfahren nach einem der vorhergehenden Ansprüche, **dadurch gekennzeichnet, dass** das Basiselement (2) eine ebene Fläche (10) aufweist, die von der wenigstens einen Ausnehmung (15) durchgriffen wird und an der die Sinterschicht (4) nach dem Befestigen des Halbleiters (3) anliegt.

4. Verfahren nach einem der vorhergehenden Ansprüche, **dadurch gekennzeichnet, dass** das Basiselement (2) derart ausgebildet wird, dass sich an die ebene Fläche (10) ein bezüglich der Fläche (10) abgewinkelter Bereich (11) des Basiselements (2) anschließt.

5. Verfahren nach einem der vorhergehenden Ansprüche, **dadurch gekennzeichnet, dass** an dem Halbleiter (3) vor dem Befestigen eine Kontaktschicht (5) angebracht wird.

6. Verfahren nach einem der vorhergehenden Ansprüche, **dadurch gekennzeichnet, dass** als Halbleiter (3) ein IGBT, eine Diode oder ein MOSFET verwendet wird.

7. Halbleiteranordnung (1) mit wenigstens einem Basiselement (2) und einem Halbleiter (3), wobei der Halbleiter (3) mittels einer Sinterschicht (4) an dem Basiselement (2) befestigt wird, **dadurch gekennzeichnet, dass** ein an der Sinterschicht (4) unmittelbar anliegender Bereich (9) des Basiselements (2) zum gezielten Anpassen der Steifigkeit des Basiselements (2) zumindest bereichsweise perforiert ist, wobei das Perforieren das Herstellen einer Vielzahl von das Basiselement (2) durchgreifenden randgeschlossenen Durchtrittsausnehmungen (15) in dem Bereich (9) des Basiselements (2) umfasst, wobei die Sinterschicht (4) auf ihrer dem Basiselement (2) zugewandten Seite plan ausgestaltet wird, sodass die Sinterschicht (4) nicht in die Durchtrittsausnehmungen (15) eingreift.

## Claims

1. Method for producing a semiconductor arrangement (1), having at least one base element (2) and one semiconductor (3), the semiconductor (3) being attached to the base element (2) by means of a sinter layer (4), **characterised in that** a region (9) of the base element (2) which is directly adjacent to the sinter layer (4) is perforated at least in regions for adjusting the stiffness of the base element (2) in a targeted manner, the perforating comprising producing, in the region (9) of the base element (2), a plurality of through-openings (15) which have a closed border and penetrate the base element (2), the sinter layer (4) being planar on the side thereof facing the base element (2), such that the sinter layer (4) does not engage into the through-openings (15).

2. Method according to claim 1, **characterised in that** the perforating is performed before the semiconductor (3) is attached to the base element (2).

3. Method according to any of the preceding claims, **characterised in that** the base element (2) has a flat surface (10) which is penetrated by the at least one opening (15) and on which the sinter layer (4) bears after the semiconductor (3) has been attached.

4. Method according to any of the preceding claims, **characterised in that** the base element (2) is formed in such a way that a region (11) of the base element (2) which is angled with respect to the surface (10) adjoins the flat surface (10).

5. Method according to any of the preceding claims, **characterised in that** a contact layer (5) is applied to the semiconductor (3) before the semiconductor is attached.

6. Method according to any of the preceding claims, **characterised in that** an IGBT, a diode or a MOSFET is used as the semiconductor (3).

7. Semiconductor arrangement (1), having at least one base element (2) and one semiconductor (3), the semiconductor (3) being attached to the base element (2) by means of a sinter layer (4), **characterised in that** a region (9) of the base element (2) which is directly adjacent to the sinter layer (4) is perforated at least in regions for adjusting the stiffness of the base element (2) in a targeted manner, the perforating comprising producing, in the region (9) of the base element (2), a plurality of through-openings (15) which have a closed border and penetrate the base element (2), the sinter layer (4) being planar on the side thereof facing the base element (2), such that the sinter layer (4) does not engage into the through-openings (15).

## Revendications

1. Procédé de fabrication d'un dispositif à semi-conducteur (1), avec au moins un élément de base (2) et un semi-conducteur (3), dans lequel le semi-conducteur (3) est fixé à l'élément de base (2) au moyen d'une couche frittée (4), **caractérisé en ce qu'**une zone (9), directement adjacente à la couche frittée (4), de l'élément de base (2) est perforée au moins par endroits en vue d'une adaptation ciblée de la rigidité de l'élément de base (2), dans lequel la perforation comprend la fabrication de plusieurs évidements traversants (15), fermés sur les bords et passant à travers l'élément de base (2), dans la zone (9) de l'élément de base (2), dans lequel la couche frittée (4) est réalisée plane sur son côté proche de l'élément de base (2), de sorte que la couche frittée (4) n'est pas en prise avec les évidements traversants (15).

2. Procédé selon la revendication 1, **caractérisé en ce que** la perforation est effectuée avant la fixation du semi-conducteur (3) à l'élément de base (2).

3. Procédé selon l'une quelconque des revendications précédentes, **caractérisé en ce que** l'élément de base (2) présente une surface plane (10) qui est traversée par l'au moins un évidement (15) et à laquelle la couche frittée (4) est adjacente après la fixation du semi-conducteur (3).

4. Procédé selon l'une quelconque des revendications précédentes, **caractérisé en ce que** l'élément de base (2) est réalisé de telle sorte que la surface plane (10) est suivie d'une zone (11), coudée par rapport à la surface (10), de l'élément de base (2).

5. Procédé selon l'une quelconque des revendications précédentes, **caractérisé en ce qu'**une couche de contact (5) est appliquée au niveau du semi-conducteur (3) avant la fixation.

6. Procédé selon l'une quelconque des revendications précédentes, **caractérisé en ce que** l'on utilise comme semi-conducteur (3) un IGBT, une diode ou un MOSFET.

7. Dispositif à semi-conducteur (1) avec au moins un élément de base (2) et un semi-conducteur (3), dans lequel le semi-conducteur (3) est fixé à l'élément de base (2) au moyen d'une couche frittée (4), **caractérisé en ce qu'**une zone (9), directement adjacente à la couche frittée (4), de l'élément de base (2) est perforée au moins par endroits en vue d'une adaptation ciblée de la rigidité de l'élément de base (2), dans lequel la perforation comprend la fabrication d'une pluralité d'évidements traversants (15), fermés sur les bords et passant à travers l'élément de base (2), dans la zone (9) de l'élément de base (2), dans lequel la couche frittée (4) est réalisée plane sur son côté proche de l'élément de base (2), de sorte que la couche frittée (4) n'est pas en prise avec les évidements traversants (15).
